# EUROPEAN PATENT SPECIFICATION

(11) **EP 4 189 293 B1**
(45) Date of publication and mention of the grant of the patent: **09.09.2026**
(21) Application number: 21745264.8
(22) Date of filing: 07.07.2021
(51) Int. Cl.: F24C 15/08, H05K 7/14, F24C 7/08

(54) **HOUSEHOLD APPLIANCE AND CONTROL PANEL ASSEMBLY AND TOUCH MODULE THEREOF**
HAUSHALTSGERÄT, BEDIENFELD UND BERÜHRUNGSMODUL DAFÜR
ENSEMBLE APPAREIL MENAGER ET PANNEAU DE COMMANDE ET SON MODULE TACTILE

(30) Priority: 27.07.2020 CN 202010730851
(43) Date of publication of application: 07.06.2023
(73) Proprietor: BSH Hausgeräte GmbH, 81739 München (DE)
(72) Inventor: ZOU, Qingqiang, Nanjing, Jiangsu 211101 (CN); ZANG, Ming, Nanjing, Jiangsu 210046 (CN); LI, Jun, Nanjing, Jiangsu 210000 (CN)
(86) International application number: PCT/EP2021/068855
(87) International publication number: WO 2022/022964

(56) References cited:
- EP-A1- 3 145 082
- EP-A2- 2 659 195
- EP-A2- 2 843 315
- EP-A2- 3 256 787
- DE-A1- 102015 214 882
- US-A1- 2013 025 579

## Description

### BACKGROUND

### Technical Field

Embodiments of the present invention relate to the field of household appliances, and in particular, to a household appliance and a control panel assembly and a touch module thereof.

### Related Art

As the intelligentization of household appliances becomes popular, an increasingly number of household appliances are controlled by a touch control panel.

Currently, the touch control panel usually includes a touch panel, a touch film, and the like. The touch film is attached to the touch panel. Because the touch panel usually contributes to the overall appearance of the touch control panel, the touch panel has a large size and a flat and smooth surface. When being attached to the touch panel, the touch film has a higher requirement for attachment precision. When a smaller touch film is attached to a larger touch panel with a flat and smooth surface, bubbles are likely to form, resulting in a higher discard rate of the touch film and further higher costs of the touch control panel. In addition, when the touch panel is damaged, because the touch film attached to the touch panel cannot be removed from the faulty touch panel for reuse, the touch panel and the touch film need to be replaced together, causing higher maintenance costs of the control panel.

EP 3 145 082 A1 shows a control panel assembly with a massive, continuous support plate for supporting a group of touch sensors.

EP 2 843 315 A2 shows a control panel assembly with a touch sensor and a support frame.

DE 10 2015 214882 A1 and WO 2012/089543 A2 respectively show a control panel assembly with mechanical springs beneath a group of touch sensors.

US 2013/025579 A1 shows a control panel assembly with a mounting opening in a touch panel.

WO 2016/126050 A2 shows a control panel assembly with a position identifier.

### SUMMARY

An objective of embodiments of the present invention is to provide a novel control panel assembly of a household appliance.

To resolve the foregoing technical problems, the embodiments of the present invention provide a control panel assembly of a household appliance. The control panel assembly includes a touch panel and a touch module. The touch module includes a touch sensor group and a support frame. The touch sensor group includes one or more touch sensors. One side of the touch sensor is adhered to the support frame, and the touch module abuts against the touch panel, so that the other side of the touch sensor is attached to the touch panel.

Compared with the prior art, the technical solutions of the embodiments of the present invention have the following beneficial effects:
The control panel assembly of the household appliance includes the touch module and the touch panel. The touch module includes the touch sensor group and the support frame. One side of the touch sensor in the touch sensor group is adhered to the support frame, and the touch module abuts against the touch panel, so that the other side of the touch sensor is attached to the touch panel. In view of that it is not necessary for the support frame to contribute to the overall appearance, the size of the support frame may be adjusted according to the size of the touch sensor, and a hole is usually provided in the surface of the support frame. Therefore, when the touch sensor is adhered to the support frame, bubbles are not likely to form. Even if bubbles form, it is easy to eliminate the bubbles through the hole, thereby effectively reducing a discard rate of the touch sensor and reducing costs by improving a yield. In addition, when the touch panel is damaged, it is only necessary to separately replace the touch panel without needing to replace the touch sensor. When the touch sensor is faulty, the touch sensor can be separately replaced. Furthermore, in some application scenarios, when a component adhered to the touch sensor needs to be replaced together, because the costs of the support frame are lower than those of the touch panel, the maintenance costs can be reduced. In summary, the costs can be reduced during both the production and maintenance of the control panel assembly.

Optionally, the support frame is made of a flexible material. Under the abutting action of an external force, the support frame tends to deform, and the deformation pushes the touch sensor, to enable the touch sensor to be as close to the touch panel as possible, so that the other side of the touch sensor is fully attached to the touch panel, or to reduce a gap between the touch panel and the other side of the touch sensor, so that the gap between the touch panel and the other side of the touch sensor is less than a set tolerance. In this way, when a user operates the touch panel, the touch module can effectively perceive a touch operation, thereby enhancing the touch sensitivity of the control panel assembly.

Optionally, the support frame includes a support portion and an elastic portion, where the elastic portion is fixed to the support portion, and the touch sensor is adhered to the elastic portion. Under the abutting of an external force, the elastic portion of the support frame deforms, to enable the touch sensor adhered to the elastic portion to be as close to the touch panel as possible, so that the other side of the touch sensor is fully attached to the touch panel, or to reduce a gap between the touch panel and the other side of the touch sensor, so that the gap between the touch panel and the other side of the touch sensor is less than a set tolerance. In this way, when a user operates the touch panel, the touch module can effectively perceive a touch operation, thereby enhancing the touch sensitivity of the control panel assembly.

Optionally, the elastic portion is integrally formed with the support portion, or the elastic portion is detachably connected to the support portion.

Optionally, the touch module further includes an electronic board for providing a light source, where the electronic board is fixed to the support frame, and the support frame is located between the touch sensor and the electronic board.

Optionally, the touch module includes a first touch module, and the first touch module includes a first touch sensor and a first support frame.

Optionally, the touch module further includes a second touch module connected to the first touch module, and the second touch module includes a second touch sensor, a second structural support frame, and a display portion.

Optionally, the control panel assembly of the household appliance further includes a positioning identifier, where the positioning identifier is located on either the touch sensor or the support frame, and is configured to locate an adhesion position of the touch sensor, so that the touch sensor can be precisely adhered at a position corresponding to the support frame.

Optionally, the control panel assembly of the household appliance further includes a printed pattern, where the printed pattern is located on a side, facing the touch sensor, of the touch panel, or the printed pattern is located on the support frame, or the printed pattern is located on the touch sensor.

Optionally, the control panel assembly of the household appliance further includes a housing, where the housing is provided with a receiving cavity, the touch module is located in the receiving cavity, and the touch panel is connected to the housing.

Optionally, the housing includes a front housing and a rear housing, where the front housing is provided with a mounting opening, and the touch panel abuts against the touch module through the mounting opening; and the rear housing is detachably connected to the front housing, and the rear housing abuts against the touch module to apply pressure to the touch module, so that the touch sensor abuts against the touch panel, thereby enhancing fitness between the touch sensor and the touch panel.

Optionally, a side, facing the front housing, of the rear housing is provided with an abutting portion, and the abutting portion abuts against the touch module, thereby further enhancing the fitness between the touch sensor and the touch panel.

Optionally, the abutting portion is elastic, to implement flexible abutting, thereby avoiding damaging the touch module.

Optionally, the abutting portion includes any one of the following: an elastic abutting column, an elastic sheet, and a spring.

Optionally, one of an inner edge of the mounting opening and an outer edge of the support frame is provided with an inlay bayonet, and the other of the inner edge of the mounting opening and the outer edge of the support frame is provided with an inlay protrusion adapted to the inlay bayonet.

An embodiment of the present invention further provides a household appliance, including any foregoing control panel assembly.

An embodiment not forming part of the claimed invention further provides a touch module of a household appliance, including a touch sensor group and a support frame, where the touch sensor group includes one or more touch sensors, and one side of the touch sensor is adhered to the support frame.

Optionally, the support frame is made of a flexible material.

Optionally, the support frame includes a support portion and an elastic portion, where the elastic portion is fixed to the support portion, and the touch sensor is adhered to the elastic portion.

Optionally, the elastic portion is integrally formed with the support portion, or the elastic portion is detachably connected to the support portion.

Optionally, the touch module further includes an electronic board for providing a light source, the electronic board is fixed to the support frame, and the support frame is located between the touch sensor and the electronic board.

Optionally, the touch module includes a first touch module, and the first touch module includes a first touch sensor and a first support frame, where the first touch module is configured to control procedure selection.

Optionally, the touch module further includes a second touch module connected to the first touch module, and the second touch module includes a second touch sensor, a second support frame, and a display portion, where the display portion is configured to display setting content.

### BRIEF DESCRIPTION OF THE DRAWINGS

FIG. 1 is a front view of a control panel assembly of a household appliance according to an embodiment of the present invention;
FIG. 2 is a rear view of a control panel assembly of a household appliance according to an embodiment of the present invention;
FIG. 3 is a cross-sectional view of FIG. 2 in a direction A-A;
FIG. 4 is a partial enlarged view of a position B of FIG. 3;
FIG. 5 is an exploded view of a control panel assembly of a household appliance according to an embodiment of the present invention;
FIG. 6 is a partial exploded view of a control panel assembly of a household appliance according to an embodiment of the present invention;
FIG. 7 is an exploded view of a touch module from a perspective according to an embodiment of the present invention;
FIG. 8 is an exploded view of a touch module from another perspective according to an embodiment of the present invention;
FIG. 9 is an exploded view of another touch module from a perspective according to an embodiment of the present invention;
FIG. 10 is an exploded view of another touch module from another perspective according to an embodiment of the present invention;
FIG. 11 is a schematic structural diagram of a rear housing according to an embodiment of the present invention; and
FIG. 12 is a schematic structural diagram of another rear housing according to an embodiment of the present invention.

### DETAILED DESCRIPTION

To make the objectives, features, and beneficial effects of the embodiments of the present invention more comprehensible, specific embodiments of the present invention are further described in detail below with reference to the accompanying drawings.

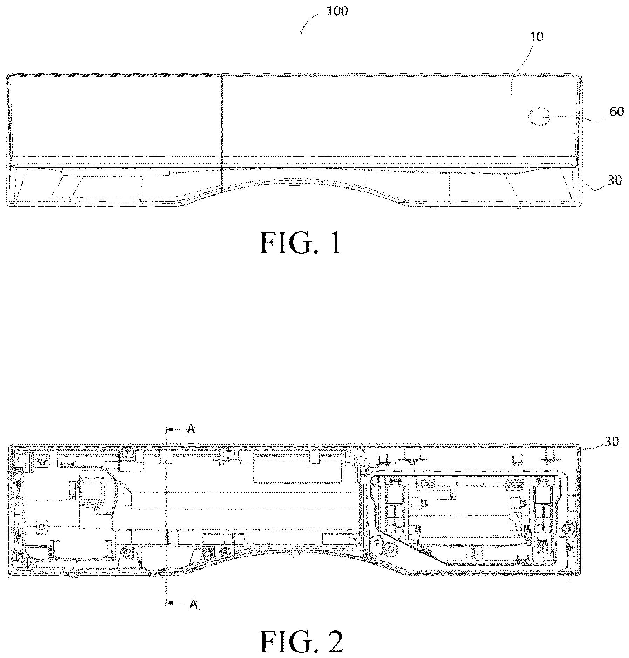

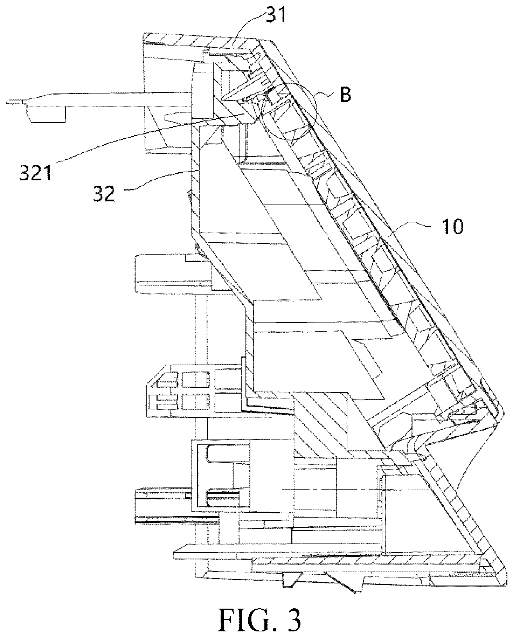

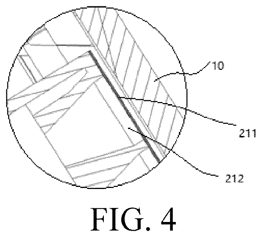

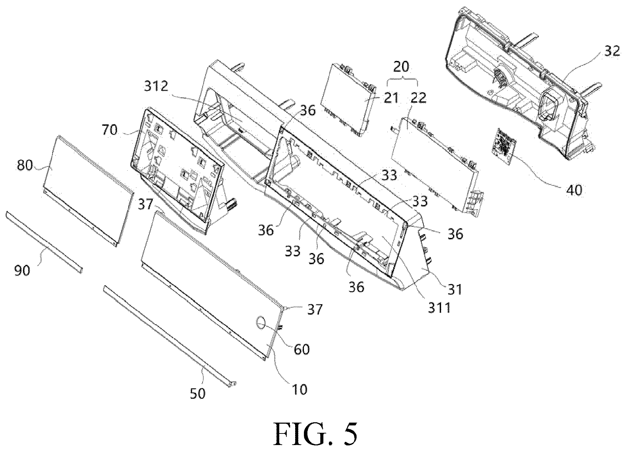

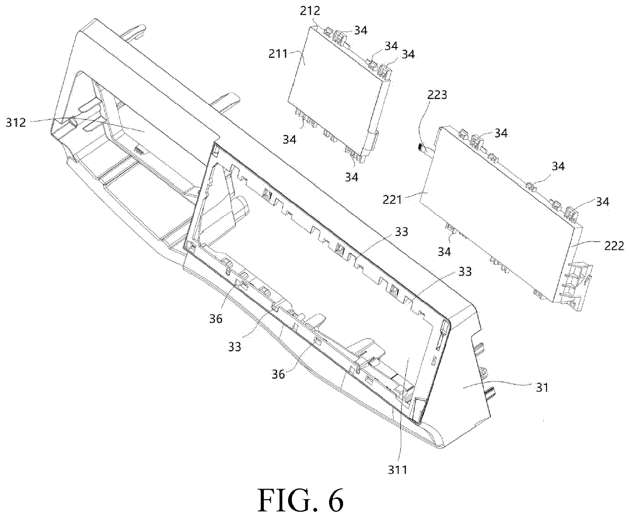

FIG. 1 is a front view of a control panel assembly of a household appliance according to an embodiment of the present invention. FIG. 2 is a rear view of a control panel assembly of a household appliance according to an embodiment of the present invention. FIG. 3 is a cross-sectional view of FIG. 2 in a direction A-A. FIG. 4 is a partial enlarged view of a position B of FIG. 3. FIG. 5 is an exploded view of a control panel assembly of a household appliance according to an embodiment of the present invention. FIG. 6 is a partial exploded view of a control panel assembly of a household appliance according to an embodiment of the present invention. The following describes the structure of a control panel assembly 100 of the household appliance with reference to FIG. 1 to FIG. 6.

During specific implementation, the control panel assembly 100 of the household appliance may include a touch panel 10 and a touch module 20. The touch panel 10 provides a user operation region. A user may operate the touch module 20 by touching, clicking/tapping, or pressing the touch panel 10.

The touch module 20 may include a touch sensor group and a structural support frame. The touch sensor group may include one or more touch sensors. One side of the touch sensor is adhered to the structural support frame, and the touch module 20 abuts against the touch panel 10, so that the other side of the touch sensor is attached to the touch panel 10.

During specific implementation, the touch sensor may be a capacitive touch sensor or a pressure type touch sensor, among other types of touch sensors. Examples are not described herein again one by one.

The size and shape of the structural support frame may be set according to the size of the touch sensor and the setting of other components.

A quantity of touch sensors in the touch sensor group may be configured according to the type of the touch sensor, a quantity of touch points supported by each touch sensor, a quantity of control procedures corresponding to functions to be implemented by the control panel assembly 100, a quantity of control items of the control procedures, a functional partition implemented by a control panel, among other factors.

In some embodiments, a power switch 60 may be disposed on the touch panel 10. The power switch 60 is configured to turn on or off the control panel assembly 100, so as to correspondingly turn on or off the household appliance.

It can be learned from the above that, the control panel assembly of the household appliance includes the touch module and the touch panel. The touch module includes the touch sensor group and the structural support frame. One side of the touch sensor in the touch sensor group is adhered to the structural support frame, and the touch module abuts against the touch panel, so that the other side of the touch sensor is attached to the touch panel. In view of that it is not necessary for the size of the structural support frame to contribute to the overall appearance, the size of the structural support frame may be adjusted according to the size of the touch sensor, and a hole is usually provided in the surface of the structural support frame. Therefore, when the touch sensor is adhered to the structural support frame, bubbles are not likely to form. Even if bubbles form, it is easy to eliminate the bubbles through the hole, thereby effectively reducing a discard rate of the touch sensor during mounting and reducing costs by improving a yield. In addition, when the touch panel is damaged, it is only necessary to separately replace the touch panel without needing to replace the touch sensor. When the touch sensor is faulty, the touch sensor can be separately replaced. Furthermore, in some application scenarios, when a component adhered to the touch sensor needs to be replaced together, because the costs of the structural support frame are lower than those of the touch panel, the maintenance costs can be reduced. In summary, the costs can be reduced during both the production and maintenance of the control panel assembly.

During actual application, an assembly error may occur during the assembly of the control panel assembly 100 of the household appliance, or during use, other components for assembling the touch module 20 may deform. Due to various factors, a gap may exist between the touch panel 10 and the touch sensor. When the gap between the touch panel 10 and the touch sensor is large, the touch sensitivity of the control panel assembly 100 may be affected or even a touch failure may occur.

To solve the problem that the large gap between the touch panel 10 and the touch sensor affects the touch sensitivity of the control panel assembly 100 or even leads to a touch failure, in the embodiments of the present invention, the following manners may be used to reduce the gap between the touch panel 10 and the touch sensor, thereby enhancing fitness between the touch sensor and the touch panel 10.

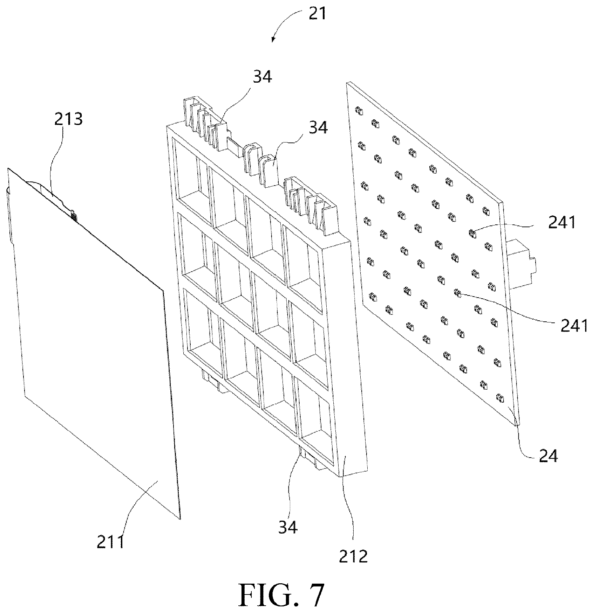

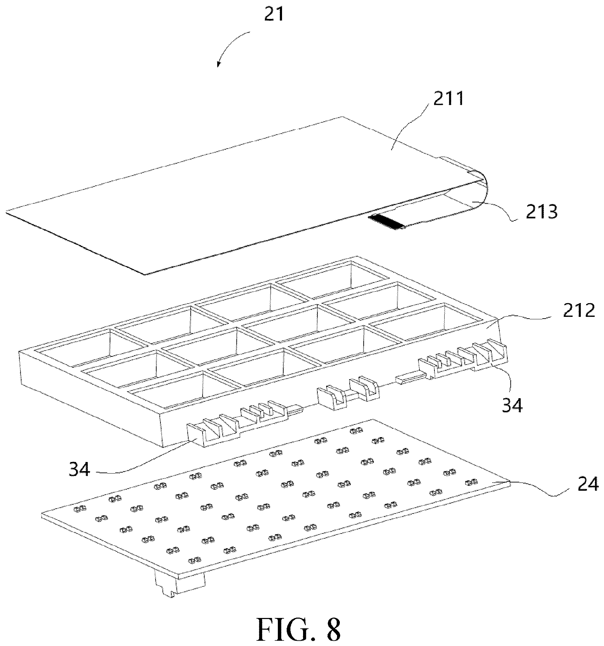

In an embodiment of the present invention, FIG. 7 and FIG. 8 are exploded views of the touch module 20 from different perspectives according to this embodiment of the present invention. The structural support frame may be made of a flexible material. Under the abutting action of an external force, the structural support frame tends to deform, and the deformation pushes the touch sensor, to enable the touch sensor to be as close to the touch panel 10 as possible, so that the other side of the touch sensor is fully attached to the touch panel 10, or to reduce a gap between the touch panel 10 and the other side of the touch sensor, so that the gap between the touch panel 10 and the other side of the touch sensor is less than a set tolerance. In this way, when the user touches, presses, or clicks/taps the touch panel 10, the touch sensor can detect an operation of the user and maintain particular touch sensitivity. The set tolerance is related to the type of the touch sensor. For example, the set tolerance may be 0.2 mm. The structural support frame made of a flexible material may also provide flexible support, thereby avoiding damaging the touch sensor. The flexible material may be polyvinyl chloride (PVC), silicon or rubber, or the like.

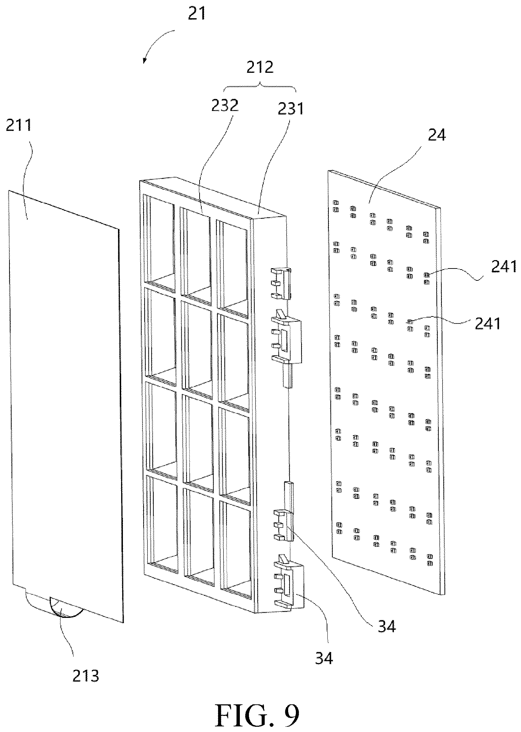

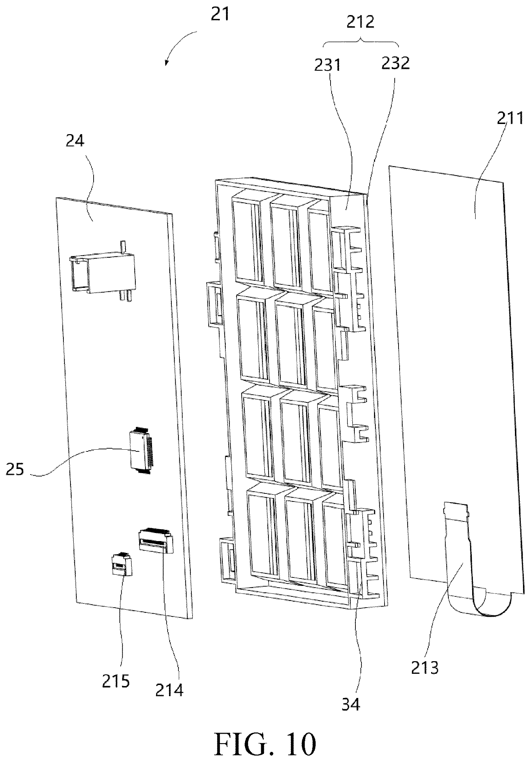

In another embodiment of the present invention, FIG. 9 and FIG. 10 are exploded views of another touch module from different perspectives according to this embodiment of the present invention. The structural support frame may include a support portion 231 and an elastic portion 232. The elastic portion 232 is fixed to the support portion 231. The touch sensor is adhered to the elastic portion 232. Under the abutting of an external force, the elastic portion 232 of the structural support frame deforms, to enable the touch sensor adhered to the elastic portion 232 to be as close to the touch panel 10 as possible, so that the other side of the touch sensor is fully attached to the touch panel 10, or to reduce a gap between the touch panel 10 and the other side of the touch sensor, so that the gap between the touch panel 10 and the other side of the touch sensor is less than a set tolerance. In this way, when a user operates the touch panel 10, the touch module 20 can effectively perceive a touch operation, thereby enhancing the touch sensitivity of the control panel assembly 100.

The elastic portion 232 may be made of rubber, silicon, or foam, among other flexible materials.

During specific implementation, the elastic portion 232 may be integrally formed with the support portion 231, for example, with a mold. The structural support frame is integrally formed through molding. In another example, based on the support portion 231, the elastic portion 232 is formed through foaming.

During specific implementation, the elastic portion 232 is detachably connected to the support portion 231. For example, the elastic portion 232 is adhered to the support portion 231. In another example, the elastic portion 232 is snapped into the support portion 231. It may be understood that, the elastic portion 232 may be alternatively detachably connected to the support portion 231 in other manners. Examples are not described herein again one by one.

During specific implementation, the shape and structure of the elastic portion 232 may be the same as or adapted to the shape and structure of the support portion 231, thereby avoiding interfering with other components.

During specific implementation, in consideration of the beautiful appearance and overall design of the control panel, the touch panel 10 is usually black and transparent. For the user to intuitively learn operations, referring to FIG. 7 to FIG. 10, the touch module 20 may further include an electronic board 24. The electronic board 24 is fixed to the structural support frame. The structural support frame is located between the touch sensor and the electronic board 24. That is, one side of the structural support frame is configured to adhere the touch sensor, and the other side of the structural support frame is configured to fix the electronic board 24. The electronic board 24 may illuminate a particular area by using a light source 241 disposed on the electronic board, so that the user intuitively learns a touch operation. The light source 241 may be a light-emitting diode (LED) or another type of light-emitting apparatus. For example, the light source 241 is an LED. When being turned on, the LED may illuminate a position corresponding to the touch panel 10.

During specific implementation, the touch module 20 may further include a control module 25. The control module 25 may be disposed on the electronic board 24. Specifically, the control module may be disposed on the other side, on which the light source 241 is not disposed, of the electronic board 24. The control module 25 is separately connected to the touch sensor and the electronic board 24, so that the control module 25 controls the light source 241 for the area corresponding to the electronic board 24 according to the touch of the touch sensor to be turned on.

The control module 25 may control, according to a control instruction sent by a terminal device interconnected with the household appliance, the household appliance to perform a corresponding procedure, and turn on a corresponding light source 241 according to a procedure option designated by the control instruction. Alternatively, the control module 25 may control the light source 241 for the area corresponding to the electronic board 24 according to the touch operation of the user to be turned on, and control the household appliance to perform the corresponding procedure, or the like.

During specific implementation, each touch sensor may be provided with a plurality of touch points. Each touch point may correspond to at least one light source 241. The corresponding light source 241 is controlled according to a triggered touch point to be turned on.

For example, the control panel assembly 100 of a washing machine may be configured with the following procedure options: start, cotton, mix, down jacket, wool, one-touch smart wash, wash/dry, rinse/spin, and the like. The procedure options separately correspond to touch points of the touch sensor one by one. When the user touches a procedure option of down jacket disposed on the touch panel 10, the light source 241 corresponding to the procedure option of down jacket is turned on. When the user touches the procedure option of one-touch smart wash disposed on the touch panel 10, the light source 241 corresponding to the procedure option of one-touch smart wash is turned on.

During specific implementation, the structural support frame may be used as a light guide plate, so that the structural support frame may support the electronic board 24 and may allow the passage of light from the light source 241. In addition, it should be considered to avoid optical crosstalk in design. To avoid optical crosstalk between light from the light sources 241, the structural support frame may be designed in the form of a plurality of boxes. The light sources 241 corresponding to each touch point are disposed in the same box. The light sources 241 corresponding to different touch points are disposed in different boxes.

During specific implementation, according to different functions of the touch module 20, the touch module 20 may include a first touch module 21. The first touch module 21 may be configured to control procedure selection. Referring to FIG. 7 to FIG. 10, the first touch module 21 may include a first touch sensor 211 and a first structural support frame 212. The first touch sensor 211 may be one touch sensor in the touch sensor group. The structural support frame may include the first structural support frame 212.

During specific implementation, the first touch sensor 211 is provided with a first connection portion 213. The first touch module 21 is provided with a first plug interface 214 adapted to the first connection portion 213. The first plug interface 214 is coupled to the control module 25, so that the control module 25 receives touch information of the first touch sensor 211, and the control module 25 controls the light source 241 of a corresponding area according to the touch information of the first touch sensor 211 to be turned on, and controls the household appliance to perform a corresponding procedure.

During specific implementation, the touch module 20 further includes a second touch module 22. Referring to FIG. 6, the second touch module 22 is connected to the first touch module 21. The second touch module 22 may include a second touch sensor 221, a second structural support frame 222, and a display portion. The display portion is configured to display setting content. The second touch sensor 221 may be one touch sensor in the touch sensor group. The structural support frame may include the second structural support frame 222.

During specific implementation, the second touch module 22 may be configured to control or adjust partial items of a procedure. For example, an item of the second touch module 22 for a washing procedure is the number of rinse cycles. The number of rinse cycles may be adjusted by using the second touch module 22. In another example, items of the second touch module 22 for a wash/dry procedure are wash and dry, wash only, dry only, dry duration, and the like. The user may operate the second touch module to choose the wash and dry, the wash only, the dry only, or the like.

Referring to FIG. 6 and FIG. 10, a second connection portion 223 is disposed on the second touch module 22. The first touch module 21 is provided with a second plug interface 215 fitting the second connection portion 223. The first touch module 21 may be connected to the second touch module 22 through the fitting between the second connection portion 223 and the second plug interface 215. Through the connection between the first touch module 21 and the second touch module 22, items in a procedure supported by the first touch module 21 and a procedure supported by the second touch module 22 can interact with each other.

Specifically, the second touch sensor is provided with a third connection portion. A third plug interface fitting the third connection portion is disposed on the second touch module 22. The third plug interface may be connected to the second connection portion 223, so that the control module 25 is connected to the second touch module 22. In this way, the control module 25 may control the second touch module 22 and receive touch information of the second touch module 22.

For example, the control module 25 can activate, according to a procedure chosen by the user by touching the first touch module 21, an item that is in the second touch module 22 and is related to the chosen procedure. After the user touches the first touch module 21 to choose the "wash/dry" procedure, items such as the wash and dry, the wash only, the dry only, a dry level, a wash duration, and the dry duration corresponding to the "wash/dry" procedure in the second touch module 22 are activated. The user may operate the activated items by touching the second touch module 22, while inactivated items are in a state of idle operation, to avoid misoperations.

The setting content displayed on the display portion may be content related to the control procedure after the first touch module 21 is triggered, or may be content related to the items of the procedure after the second touch module 22 is triggered, or may be content sent by the terminal device interconnected with the household appliance.

In a scenario that the household appliance is a washing machine, the setting content may be the weight of laundry placed in the drum of the washing machine, a motor speed, a remaining time for a selected procedure to be completed, a temperature of water added to the washing machine, or the like. It may be understood that, according to different types of household appliances, the setting content displayed on the second touch module 22 is correspondingly different. Therefore, the settings are specifically provided according to requirements of an actual application scenario.

The display portion may include a liquid crystal display (LCD) and another component having a display function. The display portion may be detachably connected to the second structural support frame 222, or may be integrally formed on the second structural support frame 222.

It may be understood that, according to the different types of household appliances and the requirements of an actual application scenario, the touch module 20 may include the first touch module 21 or may include the first touch module 21 and the second touch module 22. FIG. 7 and FIG. 10 are exemplarily exploded views of the first touch module 21. The specific structure of the second touch module 22 is similar to that of the first touch module 21. Details are not described herein again.

During specific implementation, the control panel assembly 100 of the household appliance may further include a positioning identifier. The positioning identifier may be located on either the touch sensor or the structural support frame, and configured to locate an adhesion position of the touch sensor. The positioning identifier may be a pattern, a symbol, or the like. When the touch sensor is adhered to the structural support frame, by way of image identification, the adhesion position of the touch sensor may be determined or located according to a result of the image identification of the positioning identifier, so that the touch sensor can be precisely adhered to the position corresponding to the structural support frame.

During specific implementation, for ease of user operations, the control panel assembly 100 may include a printed pattern. The printed pattern may be an icon corresponding to a control procedure. The icon may be a character, a pattern, a combination of a character and a pattern, or the like.

The printed pattern may be located on a side, facing the touch sensor, of the touch panel 10, may be located on the structural support frame, or may be located on the touch sensor.

During specific implementation, the printed pattern may be printed on the side, facing the touch sensor, of the touch panel 10 in a laser manner. Alternatively, the printed pattern may be printed on a film, and the film provided with the printed pattern is adhered to the side, facing the touch sensor, of the touch panel 10. Alternatively, the printed pattern may be disposed on the side, facing the touch sensor, of the touch panel 10 in other manners. When the printed pattern is disposed on the side, facing the touch sensor, of the touch panel 10, the definition is high, so that in a case that a touch or control panel assembly is not turned on, the user may learn positions of the procedure options on the touch panel 10 more intuitively.

During specific implementation, the printed pattern may be printed on a film, and the film printed with the pattern is adhered to the structural support frame. This manner facilitates the adhesion operation of the printed pattern.

During specific implementation, the printed pattern may be printed on the touch sensor in a laser manner. Alternatively, the printed pattern may be printed on a film, and the film provided with the printed pattern is adhered to the touch sensor. The integration of the printed pattern into the touch sensor facilitates the assembly of the control panel assembly 100.

During specific implementation, the control panel assembly 100 may further include a housing 30. The housing 30 is provided with a receiving cavity. The touch module 20 is located in the receiving cavity. The touch panel 10 is connected to the housing 30.

In the embodiments of the present invention, the housing 30 includes a front housing 31 and a rear housing 32. The front housing 31 is provided with a mounting opening 311. The touch panel 10 abuts against the touch module 20 through the mounting opening 311. The rear housing 32 is detachably connected to the front housing 31. The rear housing 32 abuts against the touch module 20 to apply pressure to the touch module 20, so that the touch sensor abuts against the touch panel 10.

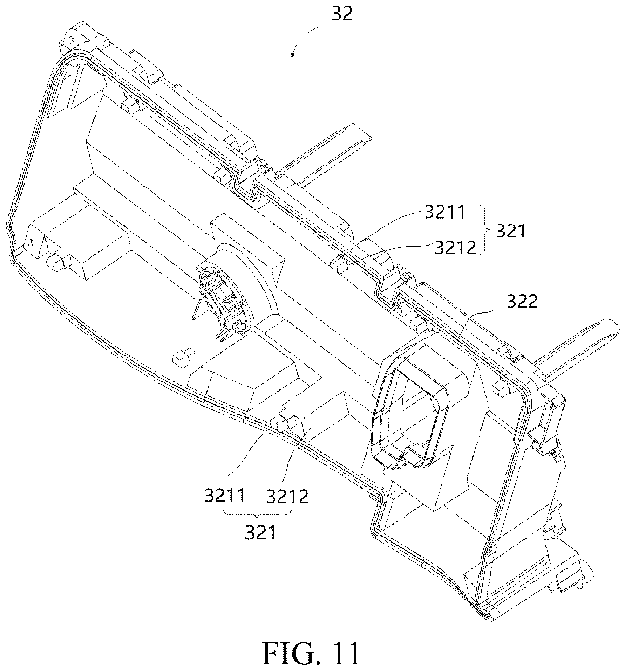

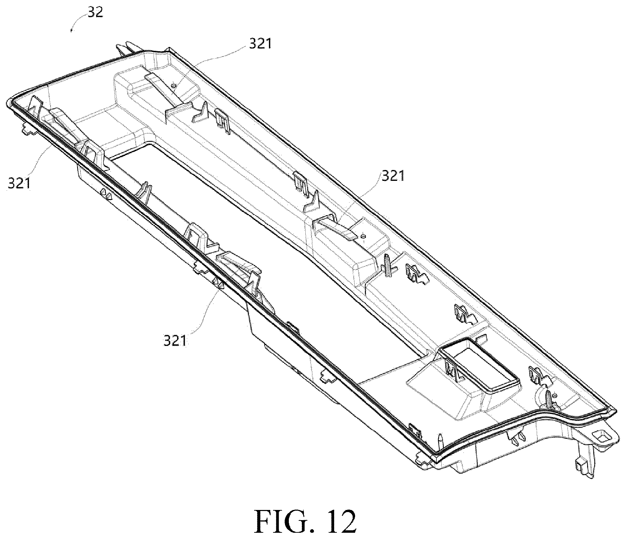

During specific implementation, FIG. 11 is a schematic structural diagram of a rear housing according to an embodiment of the present invention, and FIG. 12 is a schematic structural diagram of another rear housing according to an embodiment of the present invention. A side, facing the front housing 31, of the rear housing 32 is provided with an abutting portion 321. The abutting portion 321 abuts against the touch module 20, thereby further enhancing the fitness between the touch sensor and the touch panel 10.

It should be noted that, in the rear housing 32, other components apart from the abutting portion 321 described in the embodiments of the present invention may be disposed according to the requirements. FIG. 11 and FIG. 12 are merely schematic structural diagrams in some scenarios, and do not limit the specific structure of the rear housing 32. During actual application, there may be other cases.

During specific implementation, the abutting portion 321 is elastic, to implement flexible abutting, thereby avoiding damaging the touch module 20 when the abutting portion 321 abuts against the touch module 20. For example, when the elastic abutting portion 321 abuts against the electronic board 24 of the touch module 20, the electronic board 24 is relatively thin, and some electronic components are usually disposed on the electronic board 24. Therefore, when the elastic abutting portion 321 abuts against the electronic board 24, the abutting portion 321 can both provide a particular abutting force and effectively avoid damaging the electronic board 24.

In the embodiments of the present invention, the abutting portion 321 may be completely elastic. Alternatively, the abutting portion 321 may be partially elastic. Referring to FIG. 11, the abutting portion 321 may include an elastic abutting column 3211. The abutting portion 321 may include a matrix 3212 connected to the housing 30 and the elastic abutting column 3211 connected to the matrix 3212. The matrix 3212 and the elastic abutting column 3211 may be connected in many manners. For example, a connecting hole may be provided in the matrix 3212, and the elastic abutting column 3211 is inserted into the connecting hole. In another example, the elastic abutting column 3211 is adhered to the matrix 3212. The elastic abutting column 3211 may be made of rubber, silicon, or foam, among other flexible materials.

Referring to FIG. 12, the abutting portion 321 may include an elastic sheet. One end of the elastic sheet is fixed to the rear housing 32, and the other end is freely movable. When the elastic sheet is in a free state, the freely movable end of the elastic sheet stretches away from the rear housing 32. When the rear housing 32 is assembled on the front housing 31, the freely movable end of the elastic sheet abuts against the touch module 20.

In the specific embodiment, the abutting portion 321 may further include a spring, or the like.

During specific implementation, there may be a plurality of abutting portions 321, and the quantity of the abutting portions 321 and arrangement positions of the abutting portions on the rear housing 32 may be set according to the size and arrangement position of the touch module 20, arrangement of other components, among other factors, provided that the abutting portions can evenly abut against the touch module 20.

During specific implementation, when the rear housing 32 is connected to the front housing 31, a contacting edge of the rear housing is provided with a flexible layer 322. The flexible layer 322 may implement the sealing of the housing 30 and may implement flexible mounting of the rear housing 32 and the front housing 31, thereby avoiding mutual damage during mounting of the rear housing 32 and the front housing 31.

The flexible layer 322 may be integrally formed on the rear housing 32 or may be detachably connected to the rear housing 32. The flexible layer 322 may be made of rubber, silicon, or foam, among other flexible materials.

During specific implementation, referring to FIG. 6, one of an inner edge of the mounting opening 311 and an outer edge of the structural support frame is provided with an inlay bayonet 33, and the other of the inner edge of the mounting opening 311 and the outer edge of the structural support frame is provided with an inlay protrusion 34 adapted to the inlay bayonet 33. Specifically, the inner edge of the mounting opening 311 is provided with the inlay bayonet 33, and the outer edge of the structural support frame is provided with the inlay protrusion 34 adapted to the inlay bayonet 33. Alternatively, the outer edge of the structural support frame is provided with the inlay bayonet 33, and the inner edge of the mounting opening 311 is provided with the inlay protrusion 34 adapted to the inlay bayonet 33.

There may be a plurality of inlay protrusions 34. The inlay protrusions 34 may have the same outer contour shape or different outer contour shapes. An inner contour shape of the inlay bayonet 33 may be configured according to the outer contour shape of the corresponding inlay protrusion 34, provided that the inlay protrusion 34 is adapted to the inlay bayonet 33.

During specific implementation, one of a side, facing the touch panel 10, of the front housing 31 and a side, facing the front housing 31, of the touch panel 10 is provided with a slot 36, and the other of the side, facing the touch panel 10, of the front housing 31 and the side, facing the front housing 31, of the touch panel 10 is provided with a clamping portion 37 adapted to the slot 36. The touch panel 10 is connected to the front housing 31 through the fitting connection between the slot 36 and the clamping portion 37.

During specific implementation, referring to FIG. 5, the control panel assembly 100 of the household appliance may further include a communication module 40. The communication module 40 may be coupled to the touch module 20, and configured to establish a communication connection between the household appliance and an interconnected terminal device. In this way, the control module 25 of the touch module 20 can receive the control instruction sent by the terminal device, and the terminal device can obtain operation information of the household appliance by using the control module 25, thereby remotely controlling the household appliance by using the terminal device. The communication module 40 may be a wireless communication module.

During specific implementation, the control panel assembly 100 may further include a chrome-plated strip 50. The chrome-plated strip 50 is detachably connected to the touch panel 10, to decorate the control panel assembly 100. The chrome-plated strip 50 may be connected to the touch panel 10 in an engagement manner.

During specific implementation, according to application requirements, the control panel assembly 100 of the household appliance may further include some other components. For example, the control panel assembly 100 of the household appliance may include a drawer 70 and a drawer panel 80 connected to the drawer 70. The front housing 31 is provided with a mounting opening 312 for mounting the drawer 70. During specific implementation, a bottom end of the drawer panel 80 may further be detachably connected to a chrome-plated strip 90.

An embodiment of the present invention further provides a household appliance. The household appliance may include the control panel assembly 100. The control panel assembly 100 may use the control panel assembly 100 provided in any one of the foregoing embodiments of the present invention. For a description of the control panel assembly 100, reference may be made to the description in the foregoing embodiments of the present invention. Details are not described herein again.

An embodiment not forming part of the claimed invention further provides a touch module of a household appliance. Referring to FIG. 1 to FIG. 12, the touch module 20 may include a touch sensor group and a structural support frame. The touch sensor group includes one or more touch sensors. One side of the touch sensor is adhered to the structural support frame.

One side of the touch sensor in the touch sensor group is adhered to the structural support frame. In view of the structure of the structural support frame, it is easy to better adhere the touch sensor to the structural support frame, and bubbles are not likely to form.

When the touch sensor group and the structural support frame are used as one integral touch module 20, during assembly or maintenance, the touch sensor group and the structural support frame may be replaced as a whole, to facilitate mounting and maintenance.

During specific implementation, the structural support frame is made of a flexible material. For example, when the touch module 20 is used in the touch or control panel assembly, the structural support frame, under the abutting action of an external force, a deformation tends to enable the touch sensor to be as close to the touch panel 10 as possible, so that the other side of the touch sensor is fully attached to the touch panel 10, or to reduce a gap between the touch panel 10 and the other side of the touch sensor, so that the gap between the touch panel 10 and the other side of the touch sensor is less than the set tolerance. In this way, when the user touches, presses, or clicks/taps the touch panel 10, the touch sensor can detect an operation of the user and maintain particular touch sensitivity. The set tolerance is related to the type of the touch sensor. The structural support frame made of a flexible material may also provide flexible support, thereby avoiding damaging the touch sensor. The flexible material may be PVC, silicon or rubber, or the like.

During specific implementation, the structural support frame may include a support portion 231 and an elastic portion 232. The elastic portion 232 is fixed to the support portion 231. The touch sensor is adhered to the elastic portion 232. For example, when the touch module 20 is used in the touch or control panel assembly, under the abutting of an external force, the elastic portion 232 of the structural support frame deforms, to enable the touch sensor adhered to the elastic component to be as close to the touch panel 10 as possible, so that the other side of the touch sensor is fully attached to the touch panel 10, or to reduce a gap between the touch panel 10 and the other side of the touch sensor, so that the gap between the touch panel 10 and the other side of the touch sensor is less than a set tolerance. **In** this way, when a user operates the touch panel 10, the touch module 20 can effectively perceive a touch operation, thereby enhancing the touch sensitivity of the control panel assembly 100.

The elastic portion 232 may be made of rubber, silicon, or foam, among other flexible materials.

During specific implementation, the elastic portion 232 is integrally formed with the support portion 231. For example, with a mold, the structural support frame is integrally formed through molding. In another example, based on the support portion 231, the elastic portion 232 is formed through foaming.

During specific implementation, the elastic portion 232 is detachably connected to the support portion 231. For example, the elastic portion 232 is adhered to the support portion 231. In another example, the elastic portion 232 is snapped into the support portion 231. It may be understood that, alternatively, the elastic portion 232 may be detachably connected to the support portion 231 in other manners. Examples are not described herein again one by one.

During specific implementation, the touch module 20 may further include an electronic board 24. The electronic board 24 is fixed to the structural support frame. The structural support frame is located between the touch sensor and the electronic board 24. That is, one side of the structural support frame is configured to adhere the touch sensor, and the other side of the structural support frame is configured to fix the electronic board 24. The electronic board 24 may illuminate a particular area by using a light source 241 disposed on the electronic board, so that the user intuitively learns a touch operation.

The light source 241 may be an LED or another type of light-emitting apparatus.

During specific implementation, the touch module 20 includes a first touch module 21. The first touch module 21 includes a first touch sensor 211 and a first structural support frame 212. The first touch module 21 is configured to control procedure selection. The first touch sensor 211 may be one touch sensor in the touch sensor group. The structural support frame may include the first structural support frame 212.

During specific implementation, the first touch sensor 211 is provided with a first connection portion 213. The first touch module 21 is provided with a first plug interface 214 adapted to the first connection portion 213. The first plug interface 214 is coupled to the control module 25, so that the control module 25 receives touch information of the first touch sensor 211, and the control module 25 controls the light source 241 of a corresponding area according to the touch information of the first touch sensor 211 to be turned on, and controls the household appliance to perform a corresponding procedure.

During specific implementation, the touch module 20 may further include a second touch module 22 connected to the first touch module 21. The second touch module 22 includes a second touch sensor 221, a second structural support frame 222, and a display portion. The display portion is configured to display setting content. The second touch sensor 221 may be one touch sensor in the touch sensor group. The structural support frame may include a second structural support frame 222.

Referring to FIG. 6 and FIG. 10, a second connection portion 223 is disposed on the second touch module 22. The first touch module 21 is provided with a second plug interface 215 fitting the second connection portion 223. The first touch module 21 may be connected to the second touch module 22 through the fitting between the second connection portion 223 and the second plug interface 215. Through the connection between the first touch module 21 and the second touch module 22, items in a procedure supported by the first touch module 21 and a procedure supported by the second touch module 22 can interact with each other.

Specifically, the second touch sensor is provided with a third connection portion. A third plug interface fitting the third connection portion is disposed on the second touch module 22. The third plug interface may be connected to the second connection portion 223, so that the control module 25 is connected to the second touch module 22. In this way, the control module 25 may control the second touch module 22 and receive touch information of the second touch module 22.

The setting content displayed on the display portion may be content related to the control procedure after the first touch module 21 is triggered, or may be content related to the items of the procedure after the second touch module 22 is triggered, or may be content sent by the terminal device interconnected with the household appliance.

The display portion may include an LCD or another component having a display function. The display portion may be detachably connected to the second structural support frame 222 or may be integrally formed on the second structural support frame 222.

During specific implementation, for the structure and description of the touch module 20, reference may be made to the description of the control panel assembly 100 provided in the foregoing embodiments of the present invention. Details are not described herein again.

Although specific implementations have been described above, these implementations are not intended to limit the scope of the present disclosure, even if only one implementation is described with respect to specific features. The feature examples provided in the present invention are intended to be illustrative rather than limiting, unless different expressions are made.

Although the present invention is disclosed above, the present invention is not limited thereto. Any person skilled in the art can make various changes and modifications without departing from the scope of the present invention, and therefore the protection scope of the present invention should be subject to the scope defined by the claims.

## Claims

1. A control panel assembly (100) of a household appliance, comprising
- a touch panel (10) and
- a touch module (20),
**characterised in that** the touch module (20) comprises a
- touch sensor group and
- a support frame (212, 222),
wherein the touch sensor group comprises one or more touch sensors (211, 221),
wherein one side of the touch sensor (211, 221) is adhered to the support frame (212, 222), and the touch module (20) abuts against the touch panel (10), so that the other side of the touch sensor (211, 221) is attached to the touch panel (10).

2. The control panel assembly (100) of a household appliance according to claim 1, wherein the touch sensor (211, 221) is adhered to
- a flexible material which the support frame (212, 222) is made of; or
- an elastic portion (232) of the support frame (212, 222) being fixed to, integrally formed with or detachably connected to a support portion (231) of the support frame (212, 222).

3. The control panel assembly (100) of a household appliance according to claim 1, **characterized in that** the support frame (212, 222) is made of a flexible material.

4. The control panel assembly (100) of a household appliance according to claim 1, **characterized in that** the support frame (212, 222) comprises the support portion (231) and the elastic portion (232), the elastic portion (232) is fixed to the support portion (231), and the touch sensor (211, 221) is adhered to the elastic portion (232).

5. The control panel assembly (100) of a household appliance according to claim 4, **characterized in that** the elastic portion (232) is integrally formed with the support portion (231), or the elastic portion (232) is detachably connected to the support portion (231).

6. The control panel assembly (100) of a household appliance according to claim 1, **characterized in that** the touch module (20) further comprises an electronic board (24) for providing a light source (241), the electronic board (24) is fixed to the support frame (212, 222), and the support frame (212, 222) is located between the touch sensor (211, 221) and the electronic board (24).

7. The control panel assembly (100) of a household appliance according to claim 1, **characterized in that** the touch module (20) comprises a first touch module (21), and the first touch module (21) comprises a first touch sensor (211) and a first support frame (212), wherein the first touch module (21) is configured to control procedure selection.

8. The control panel assembly (100) of a household appliance according to claim 7, **characterized in that** the touch module (20) further comprises a second touch module (22) connected to the first touch module (21), and the second touch module (22) comprises a second touch sensor (221), a second support frame (222), and a display portion, wherein the display portion is configured to display setting content.

9. The control panel assembly (100) of a household appliance according to claim 1, **characterized by** further comprising a positioning identifier, wherein the positioning identifier is located on either the touch sensor (211, 221) or the support frame (212, 222), and is configured to locate an adhesion position of the touch sensor (211, 221).

10. The control panel assembly (100) of a household appliance according to claim 1, **characterized by** further comprising a printed pattern, wherein the printed pattern is located
- on a side, facing the touch sensor (211, 221), of the touch panel (10),
- on the support frame (212, 222), or
- on the touch sensor (211, 221).

11. The control panel assembly (100) of a household appliance according to any one of claims 1 to 10, **characterized by** further comprising a housing (30), wherein the housing (30) is provided with a receiving cavity, the touch module (20) is located in the receiving cavity, and the touch panel (10) is connected to the housing (30).

12. The control panel assembly (100) of a household appliance according to claim 11, **characterized in that** the housing (30) comprises a front housing (31) and a rear housing (32), wherein
the front housing (31) is provided with a mounting opening (311), and the touch panel (10) abuts against the touch module (20) through the mounting opening (311); and
the rear housing (32) is detachably connected to the front housing (31), and the rear housing (32) abuts against the touch module (20) to apply pressure to the touch module (20), so that the touch sensor (211, 221) abuts against the touch panel (10).

13. The control panel assembly (100) of a household appliance according to claim 12, **characterized in that** a side, facing the front housing (31), of the rear housing (32) is provided with an abutting portion (321), and the abutting portion (321) abuts against the touch module (20).

14. The control panel assembly (100) of a household appliance according to claim 13, **characterized in that** the abutting portion (321) is elastic.

15. The control panel assembly (100) of a household appliance according to claim 14, **characterized in that** the abutting portion (321) comprises any one of the following: an elastic abutting column (3211), an elastic sheet, and a spring.

16. The control panel assembly (100) of a household appliance according to claim 12, **characterized in that** one of an inner edge of the mounting opening (311) and an outer edge of the support frame (212, 222) is provided with an inlay bayonet (33) for engagement with an inlay protrusion (34) adapted thereto, and the other of the inner edge of the mounting opening (311) and the outer edge of the support frame (212, 222) is provided with the inlay protrusion (34) adapted to engage with the inlay bayonet (33).

17. A household appliance, **characterized by** comprising the control panel assembly (100) according to any one of claims 1 to 16.

## Patentansprüche

1. Bedienpaneelbaugruppe (100) eines Haushaltsgeräts, umfassend
- ein Berührungspaneel (10) und
- ein Berührungsmodul (20), **dadurch gekennzeichnet, dass** das Berührungsmodul (20) Folgendes umfasst:
- eine Berührungssensorgruppe und
- einen Tragrahmen (212, 222),
wobei die Berührungssensorgruppe einen oder mehrere Berührungssensoren (211, 221) umfasst,
wobei eine Seite des Berührungssensors (211, 221) an den Tragrahmen (212, 222) geklebt ist und das Berührungsmodul (20) an dem Berührungspaneel (10) anliegt, so dass die andere Seite des Berührungssensors (211, 221) an dem Berührungspaneel (10) befestigt ist.

2. Bedienpaneelbaugruppe (100) eines Haushaltsgeräts nach Anspruch 1,
wobei der Berührungssensor (211, 221) an Folgendes geklebt ist:
- ein flexibles Material, aus dem der Tragrahmen (212, 222) hergestellt ist; oder
- einen elastischen Abschnitt (232) des Tragrahmens (212, 222), der an einem Tragabschnitt (231) des Tragrahmens (212, 222) fixiert, einstückig damit ausgebildet oder lösbar damit verbunden ist.

3. Bedienpaneelbaugruppe (100) eines Haushaltsgeräts nach Anspruch 1, **dadurch gekennzeichnet, dass** der Tragrahmen (212, 222) aus einem flexiblen Material hergestellt ist.

4. Bedienpaneelbaugruppe (100) eines Haushaltsgeräts nach Anspruch 1, **dadurch gekennzeichnet, dass** der Tragrahmen (212, 222) den Tragabschnitt (231) und den elastischen Abschnitt (232) umfasst, der elastische Abschnitt (232) an dem Tragabschnitt (231) fixiert ist und der Berührungssensor (211, 221) an den elastischen Abschnitt (232) geklebt ist.

5. Bedienpaneelbaugruppe (100) eines Haushaltsgeräts nach Anspruch 4, **dadurch gekennzeichnet, dass** der elastische Abschnitt (232) einstückig mit dem Tragabschnitt (231) ausgebildet ist oder der elastische Abschnitt (232) lösbar mit dem Tragabschnitt (231) verbunden ist.

6. Bedienpaneelbaugruppe (100) eines Haushaltsgeräts nach Anspruch 1, **dadurch gekennzeichnet, dass** das Berührungsmodul (20) ferner eine Elektronikplatine (24) zum Bereitstellen einer Lichtquelle (241) umfasst, die Elektronikplatine (24) an dem Tragrahmen (212, 222) fixiert ist und sich der Tragrahmen (212, 222) zwischen dem Berührungssensor (211, 221) und der Elektronikplatine (24) befindet.

7. Bedienpaneelbaugruppe (100) eines Haushaltsgeräts nach Anspruch 1, **dadurch gekennzeichnet, dass** das Berührungsmodul (20) ein erstes Berührungsmodul (21) umfasst und das erste Berührungsmodul (21) einen ersten Berührungssensor (211) und einen ersten Tragrahmen (212) umfasst, wobei das erste Berührungsmodul (21) konfiguriert ist, eine Vorgangsauswahl zu steuern.

8. Bedienpaneelbaugruppe (100) eines Haushaltsgeräts nach Anspruch 7, **dadurch gekennzeichnet, dass** das Berührungsmodul (20) ferner ein zweites Berührungsmodul (22) umfasst, das mit dem ersten Berührungsmodul (21) verbunden ist, und das zweite Berührungsmodul (22) einen zweiten Berührungssensor (221), einen zweiten Tragrahmen (222) und einen Anzeigeabschnitt umfasst, wobei der Anzeigeabschnitt konfiguriert ist, einen Einstellungsinhalt anzuzeigen.

9. Bedienpaneelbaugruppe (100) eines Haushaltsgeräts nach Anspruch 1, **dadurch gekennzeichnet, dass** sie ferner eine Positionierungskennung umfasst, wobei sich die Positionierungskennung entweder auf dem Berührungssensor (211, 221) oder dem Tragrahmen (212, 222) befindet und konfiguriert ist, eine Klebeposition des Berührungssensors (211, 221) zu lokalisieren.

10. Bedienpaneelbaugruppe (100) eines Haushaltsgeräts nach Anspruch 1, **dadurch gekennzeichnet, dass** sie ferner ein gedrucktes Muster umfasst, wobei sich das gedruckte Muster wie folgt befindet:
- auf einer dem Berührungssensor (211, 221) zugewandten Seite des Berührungspaneels (10),
- auf dem Tragrahmen (212, 222) oder
- auf dem Berührungssensor (211, 221).

11. Bedienpaneelbaugruppe (100) eines Haushaltsgeräts nach einem der Ansprüche 1 bis 10, **dadurch gekennzeichnet, dass** sie ferner ein Gehäuse (30) umfasst, wobei das Gehäuse (30) mit einem Aufnahmehohlraum bereitgestellt ist, sich das Berührungsmodul (20) in dem Aufnahmehohlraum befindet und das Berührungspaneel (10) mit dem Gehäuse (30) verbunden ist.

12. Bedienpaneelbaugruppe (100) eines Haushaltsgeräts nach Anspruch 11, **dadurch gekennzeichnet, dass** das Gehäuse (30) ein vorderes Gehäuse (31) und ein hinteres Gehäuse (32) umfasst, wobei
das vordere Gehäuse (31) mit einer Anbringungsöffnung (311) bereitgestellt ist und das Berührungspaneel (10) durch die Anbringungsöffnung (311) an dem Berührungsmodul (20) anliegt; und
das hintere Gehäuse (32) lösbar mit dem vorderen Gehäuse (31) verbunden ist und das hintere Gehäuse (32) an dem Berührungsmodul (20) anliegt, um Druck auf das Berührungsmodul (20) anzuwenden, so dass der Berührungssensor (211, 221) an dem Berührungspaneel (10) anliegt.

13. Bedienpaneelbaugruppe (100) eines Haushaltsgeräts nach Anspruch 12, **dadurch gekennzeichnet, dass** eine dem vorderen Gehäuse (31) zugewandte Seite des hinteren Gehäuses (32) mit einem anliegenden Abschnitt (321) bereitgestellt ist und der anliegende Abschnitt (321) an dem Berührungsmodul (20) anliegt.

14. Bedienpaneelbaugruppe (100) eines Haushaltsgeräts nach Anspruch 13, **dadurch gekennzeichnet, dass** der anliegende Abschnitt (321) elastisch ist.

15. Bedienpaneelbaugruppe (100) eines Haushaltsgeräts nach Anspruch 14, **dadurch gekennzeichnet, dass** der anliegende Abschnitt (321) eines von Folgendem umfasst: eine elastische anliegende Stütze (3211), eine elastische Platte und eine Feder.

16. Bedienpaneelbaugruppe (100) eines Haushaltsgeräts nach Anspruch 12, **dadurch gekennzeichnet, dass** eines von einer inneren Kante der Anbringungsöffnung (311) und einer äußeren Kante des Tragrahmens (212, 222) mit einem Einlegebajonett (33) zum Eingriff in einen daran angepassten Einlegevorsprung (34) bereitgestellt ist und das andere von der inneren Kante der Anbringungsöffnung (311) und der äußeren Kante des Tragrahmens (212, 222) mit dem Einlegevorsprung (34) bereitgestellt ist, der angepasst ist, um in das Einlegebajonett (33) einzugreifen.

17. Haushaltsgerät, **dadurch gekennzeichnet, dass** es die Bedienpaneelbaugruppe (100) nach einem der Ansprüche 1 bis 16 umfasst.

## Revendications

1. Ensemble de panneau de commande (100) pour appareil électroménager, comprenant
- un panneau tactile (10) et
- un module tactile (20),
**caractérisé en ce que** le module tactile (20) comprend
- un groupe de capteurs tactiles et
- un cadre de support (212, 222),
dans lequel le groupe de capteurs tactiles comprend un ou plusieurs capteurs tactiles (211, 221),
dans lequel une face du capteur tactile (211, 221) est collée au cadre de support (212, 222) et le module tactile (20) vient en appui contre le panneau tactile (10), de sorte que l'autre face du capteur tactile (211, 221) est fixée au panneau tactile (10).

2. Ensemble de panneau de commande (100) pour appareil électroménager selon la revendication 1,
dans lequel le capteur tactile (211, 221) est collé :
- à un matériau flexible dont le cadre de support (212, 222) est constitué, ou
- à une portion élastique (232) du cadre de support (212, 222) étant fixée à, formée d'un seul tenant avec ou reliée de façon amovible à une portion de support (231) du cadre de support (212, 222).

3. Ensemble de panneau de commande (100) pour appareil électroménager selon la revendication 1, **caractérisé en ce que** le cadre de support (212, 222) est constitué d'un matériau flexible.

4. Ensemble de panneau de commande (100) pour appareil électroménager selon la revendication 1, **caractérisé en ce que** le cadre de support (212, 222) comprend la portion de support (231) et la portion élastique (232), la portion élastique (232) est fixée à la portion de support (231), et le capteur tactile (211, 221) est collé à la portion élastique (232).

5. Ensemble de panneau de commande (100) pour appareil électroménager selon la revendication 4, **caractérisé en ce que** la portion élastique (232) est formée d'un seul tenant avec la portion de support (231) ou la portion élastique (232) est reliée de façon amovible à la portion de support (231).

6. Ensemble de panneau de commande (100) pour appareil électroménager selon la revendication 1, **caractérisé en ce que** le module tactile (20) comprend en outre une carte électronique (24) apte à fournir une source de lumière (241), la carte électronique (24) est fixée au cadre de support (212, 222) et le cadre de support (212, 222) est situé entre le capteur tactile (211, 221) et la carte électronique (24).

7. Ensemble de panneau de commande (100) pour appareil électroménager selon la revendication 1, **caractérisé en ce que** le module tactile (20) comprend un premier module tactile (21), et le premier module tactile (21) comprend un premier capteur tactile (211) et un premier cadre de support (212), dans lequel le premier module tactile (21) est configuré pour commander la sélection d'un programme de fonctionnement.

8. Ensemble de panneau de commande (100) pour appareil électroménager selon la revendication 7, **caractérisé en ce que** le module tactile (20) comprend en outre un deuxième module tactile (22) relié au premier module tactile (21) et le deuxième module tactile (22) comprend un deuxième capteur tactile (221), un deuxième cadre de support (222) et une portion d'affichage, la portion d'affichage étant configurée pour afficher des informations de paramétrage.

9. Ensemble de panneau de commande (100) pour appareil électroménager selon la revendication 1, **caractérisé en ce qu'**il comprend en outre un repère de positionnement, dans lequel le repère de positionnement est situé soit sur le capteur tactile (211, 221) soit sur le cadre de support (212, 222), et est configuré pour situer une zone d'adhésion du capteur tactile (211, 221).

10. Ensemble de panneau de commande (100) pour appareil électroménager selon la revendication 1, **caractérisé en ce qu'**il comprend en outre un motif imprimé, ledit motif imprimé étant situé
- sur un côté du panneau tactile (10) faisant face au capteur tactile (211, 221),
- sur le cadre de support (212, 222), ou
- sur le capteur tactile (211, 221).

11. Ensemble de panneau de commande (100) pour appareil électroménager selon l'une quelconque des revendications 1 à 10, **caractérisé en ce qu'**il comprend en outre un boîtier (30), dans lequel le boîtier (30) est pourvu d'une cavité réceptrice, le module tactile (20) est situé dans cette cavité réceptrice et le panneau tactile (10) est assemblé au boîtier (30).

12. Ensemble de panneau de commande (100) pour appareil électroménager selon la revendication 11, **caractérisé en ce que** le boîtier (30) comprend un boîtier frontal (31) et un boîtier arrière (32), dans lequel
le boîtier frontal (31) est pourvu d'une ouverture de montage (311), et le panneau tactile (10) vient en appui contre le module tactile (20) via l'ouverture de montage (311), et
le boîtier arrière (32) est relié de façon amovible au boîtier frontal (31), et le boîtier arrière (32) vient en butée contre le module tactile (20) afin d'appliquer une pression sur le module tactile (20), de sorte que le capteur tactile (211, 221) bute contre le panneau tactile (10).

13. Ensemble de panneau de commande (100) pour appareil électroménager selon la revendication 12, **caractérisé en ce qu'**un côté du boîtier arrière (32) faisant face au boîtier avant (31) est muni d'une portion de butée (321), et la portion de butée vient en appui contre le module tactile (20).

14. Ensemble de panneau de commande (100) pour appareil électroménager selon la revendication 13, **caractérisé en ce que** la portion de butée (321) est élastique.

15. Ensemble de panneau de commande (100) pour appareil électroménager selon la revendication 14, **caractérisé en ce que** la portion de butée (321) comprend l'un quelconque des suivants : un plot de butée élastique (3211), un film élastique et un ressort.

16. Ensemble de panneau de commande (100) pour appareil électroménager selon la revendication 12, **caractérisé en ce que** l'un parmi le bord intérieur de l'ouverture de montage (311) et le bord extérieur du cadre de support (212, 222) est muni d'une baïonnette d'insert (33) apte à venir en prise avec une saillie d'insert (34) complémentaire, et l'autre parmi le bord intérieur de l'ouverture de montage (311) et le bord extérieur du cadre de support (212, 222) est muni de la saillie d'insert (34) adaptée pour venir en prise avec la baïonnette d'insert (33).

17. Appareil électroménager, **caractérisé en ce qu'**il comprend l'ensemble de panneau de commande (100) selon l'une quelconque des revendications 1 à 16.
